# EUROPÄISCHE PATENTSCHRIFT

(11) **EP 2 693 495 B1**
(45) Veröffentlichungstag und Bekanntmachung des Hinweises auf die Patenterteilung: **09.09.2020**
(21) Anmeldenummer: 12005554.6
(22) Anmeldetag: 31.07.2012
(51) Int. Cl.: H01L 31/02, H01L 31/054, H01L 31/048

(54) **Solarzelleneinheit**
Solar cell unit
Unité de cellules solaires

(43) Veröffentlichungstag der Anmeldung: 05.02.2014
(73) Patentinhaber: AZURSPACE Solar Power GmbH, 74072 Heilbronn (DE)
(72) Erfinder: Khorenko, Victor, Dr., 74196 Neuenstadt a.K. (DE); Zrinscak, Ivica, Dr., 74074 Heilbronn (DE)
(74) Vertreter: Koch Müller Patentanwaltsgesellschaft mbH

(56) Entgegenhaltungen:
- EP-A1- 2 073 279
- EP-A1- 2 278 631
- EP-A1- 2 312 646
- DE-A1-102011 084 054
- US-A1- 2009 120 500
- US-A1- 2011 240 096
- ANDREEV V M ET AL: "DEVELOPMENT OF PV RECEIVERS FOR SPACE LINE-FOCUS CONCENTRATOR MODULES", CONFERENCE RECORD OF THE 25TH. IEEE PHOTOVOLTAIC SPECIALISTS CONFERENCE 1996. WASHINGTON, MAY 13 - 17, 1996; [CONFERENCE RECORD OF THE IEEE PHOTOVOLTAIC SPECIALISTS CONFERENCE], NEW YORK, IEEE, US, vol. CONF. 25, no. CONF. 25, 13 May 1996 (1996-05-13), pages 341-344, XP000896925, ISBN: 978-0-7803-3167-9

## Beschreibung

Die Erfindung betrifft eine Solarzelleneinheit gemäß dem Oberbegriff des Patentanspruchs 1.

Aus der EP 2 073 279 A1 ist ein Solarzellenmodul bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an vier Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht. Auch sind aus der US 2011/ 0240096 A1 und aus Andreev V M et al; Conference record of the 25th. IEEE Photovoltaic specialists vonference 1996, IEEE, Bd. Conf. 25, 13. Mai 1996; Seiten 341-344 Solarzelleneinheiten bekannt. Aus der EP 1 953 825 A2 ist eine weitere Solarzelleneinheit bekannt. Hierbei wird auf einem Träger ein als Solarzelle ausgebildeter Halbleiterkörper angeordnet. Anschließend werden zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Aus der DE 10 2009 006 286 A1 ist eine Solarzelleneinheit bekannt, welche eine Vielzahl von einzelnen Solarzellen auf einem Träger aufweist. Unter anderem ist oberhalb der Solarzelle ein optisches Element, welches auch als sekundäres optisches Element "SOE" bezeichnet wird, angeordnet. Das optische Element leitet das durch eine Fresnellinse fokussierte Licht der Sonne auf die Oberfläche der Solarzelle. Mittels der fokussierenden Anordnung lassen sich mit wenigen kleinen Solarzellen, welche einen Wirkungsgrad bis zu 40% und darüber aufweisen, großflächige Solarzelleneinheiten aufbauen. Des Weiteren sind aus der US 2009 / 120500 A1, der EP 2 278 631, der EP 2 312 646 A1 und der DE 10 2011 084054 A1 derartige Vorrichtungen offenbart.

Vor diesem Hintergrund besteht die Aufgabe der Erfindung darin, eine Vorrichtung anzugeben, die den Stand der Technik weiterbildet.

Die Aufgabe wird durch eine Solarzelleneinheit mit den Merkmalen des Patentanspruchs 1 gelöst. Vorteilhafte Ausgestaltungen der Erfindung sind Gegenstand von Unteransprüchen.

Gemäß dem Gegenstand der Erfindung weist die Solarzelleneinheit unter anderem einen als Solarzelle ausgebildeten Halbleiterkörper auf, wobei der Halbleiterkörper eine Vorderseite mit einem ersten elektrischen Anschluss und eine Rückseite mit einem zweiten elektrischen Anschluss und eine zwischen der Vorderseite und der Rückseite ausgebildete Seitenfläche aufweist, und mit einem Träger mit einer Oberseite und einer Unterseite, wobei der Träger auf der Oberseite einen ersten als Tell des Trägers ausgebildeten Leiterbahnbereich aufweist und der erste elektrische Anschluss mit dem ersten Leiterbahnbereich elektrisch verschaltet Ist, und der Träger auf der Oberseite einen zweiten als Teil des Trägers ausgebildeten Leiterbahnbereich aufweist und der zweite elektrische Anschluss mit dem zweiten Leiterbahnbereich elektrisch verschaltet Ist, und mit einem sekundären optischen Element, das eine Unterseite aufweist und Licht auf die Vorderseite des Halbleiterkörpers führt und das optische Element an der gesamten Unterseite eine plane Oberfläche aufweist und ein Tell der planen Oberfläche oberhalb der Vorderseite des Halbleiterkörpers angeordnet ist und ein Teil der Unterseite des optischen Elements eine stoffschlüssig mit der Unterseite verbundene erste Haftvermittlerschicht aufweist und wobei eine Polymerkleberschicht wenigstens zwischen der Haftvermittlerschicht und der Vorderseite des Halbleiterkörpers ausgebildet ist.

Es sei angemerkt, dass es sich bei der Solarzelle vorzugsweise um eine III-V Halbleitersolarzelle auf GaAs Basis handelt und die Solarzelle höchst vorzugsweise als stapelförmig angeordnete Mehrfachsolarzelle ausgebildet ist und unter anderem mittels Nutzung von UV-Lichtanteilen Wirkungsgrade oberhalb 30% aufweist. Derartige Solarzelleneinheiten werden, unter anderem wegen den im Vergleich zu den Siliziumsolarzellen höheren Herstellkosten, bevorzugt In sogenannten CPV-Systemen eingesetzt. In den CPV-Systemen wird das Sonnenlicht um Faktoren oberhalb von 50 gebündelt. Hierbei wird das mittels eines primären optischen Konzentrators bzw. Elements gebündelte Licht auf ein sekundäres optisches Element geleitet. Das Primäre Element ist oberhalb des sekundären optischen Elements angeordnet. Von dem sekundären optischen Element wird das Licht durch die Polymerkleberschicht hindurch auf die Vorderseite der Solarzelle geleitet.

Um die optischen Verluste gering zu halten, muss die Polymerkleberschicht neben einer hohen UV-Beständigkeit auch in dem gesamten auszunutzenden Spektralbereich besonders transparent ausgebildet sein. Außerdem werden durch die hohe Konzentration des Sonnenlichtes hohe Temperaturen von bis zu 120°C auf der Vorderseite der Solarzelle erzielt, d.h. die Polymerkleberschicht muss besonders temperatur- und alterungsbeständig ausgeführt sein. Es versteht sich, dass die Haftvermittlerschicht Im Vergleich zu der Polymerkleberschicht eine unterschiedliche chemische Zusammensetzung aufweist. Untersuchungen haben gezeigt, dass bereits eine Ausbildung der Polymerkleberschicht in dem Zentralbereich an der Unterseite des optischen Elements und hierdurch auch die Vorderseite eine kraftschlüssige Verbindung herstellt.

Ein Vorteil der erfindungsgemäßen Vorrichtung ist es, dass das sekundäre optische Element eine plane Oberfläche aufweist und sich hierdurch einfach und kostengünstig herstellen lässt. Indem zwischen der Unterseite des sekundären optischen Elements und der Oberseite des Trägers bzw. der Vorderseite der Solarzelle eine Polymerkleberschicht, die vorzugsweise eine Silikonverbindung umfasst, ausgebildet Ist, lässt sich ohne weitere Verbindungsmittel eine kraftschlüssige Verbindung auf einfache und kostengünstige Weise herstellen. Es versteht sich, dass zwischen Vorderseite der Solarzelle und der Unterseite des sekundären optischen Elements die Polymerkleberschicht eine geringe Dicke, vorzugsweise unterhalb 2 mm, höchst vorzugsweise unterhalb 0,5 mm ausgebildet ist. Untersuchungen haben gezeigt, dass sich die Haftung zwischen der Polymerkleberschicht und der planen Unterseite des sekundären optischen Elements mit der Ausbildung einer dünnen Haftvermittlerschicht wesentlich erhöhen und hierdurch die Zuverlässigkeit steigern lässt. Es Ist bevorzugt, die Haftvermittlerschicht transparent und sehr dünn auszuführen, vorzugsweise beträgt die Dicke weniger als 0,5 mm, höchst vorzugsweise weniger als 0,05 mm. Es zeigt sich, dass die Polymerkleberschicht dichtende Eigenschaften aufweist und die Oberseite des Trägers sowie den Halbleiterkörper und insbesondere die Seitenflächen des Halbleiterkörpers durch die Polymerkleberschicht zuverlässig vor Umgebungseinflüssen geschützt sind. Weitere Untersuchungen haben gezeigt, dass eine zusätzliche Abdichtungsschicht, die insbesondere den äußeren Rand der kissenförmig ausgebildeten Polymerkleberschicht umschließt, sich erübrigt. Hierdurch lässt sich die Anzahl der Fertigungsschritte zur Herstellung der Solarzelleneinheit weiter reduzieren. Ein Vorteil der kissenförmigen Ausbildung der Polymerkleberschicht unterhalb der planen Oberfläche ist, dass eine Begrenzung für eine laterale Ausdehnung der Polymerkleberschicht fehlt. Eine Ausdehnung oder ein Schrumpfen der Polymerkleberschicht sowohl senkrecht zu der Richtung der Oberseite des Trägers als auch senkrecht zu der Richtung infolge einer Temperaturänderung und / oder Feuchtigkeitsänderung ist hierdurch ohne weiters möglich. Hierdurch lässt sich die Wahrscheinlichkeit für eine Delamination zwischen der Polymerkleberschicht und dem Träger reduzieren.

In einer Weiterbildung ist zwischen der Polymerkleberschicht und der Vorderseite des Halbleiterkörpers eine zweite Haftvermittlerschicht ausgebildet und die zweite Haftvermittlerschicht mit der Vorderseite des Halbleiterkörpers stoffschlüssig verbunden. Mit der Ausbildung der zweiten Haftvermittlerschicht lässt sich die Zuverlässigkeit weiter erhöhen. Gemäß einer alternativen Ausführungsform ist die zweite Haftvermittlerschicht auch auf der Oberseite des Trägers ausgebildet. In einer anderen Weiterbildung ist die erste Haftvermittlerschicht mit der gesamten Unterseite des sekundären optischen Elements stoffschlüssig verbunden.

Erfindungsgemäß ist die Polymerkleberschicht als Vergussmasse an der gesamten Unterseite ausgebildet, wobei die Vorderseite des Halbleiterkörpers und die Seitenflächen des Halbleiterkörpers formschlüssig überdeckt sind. Die Polymerkleberschicht ist kissenförmig zwischen der Unterseite des sekundären optischen Elementes und der Oberseite des Trägers ausgebildet. Gemäß einer alternativen Ausführungsform, die nicht Gegenstand der vorliegenden Erfindung ist, schließt die Polymerkleberschicht bündig mit dem Rand an der Unterseite des sekundären optischen Elements ab. In einer anderen alternativen Ausführungsform ragt die Polymerkleberschicht seitlich an der Unterseite des sekundären optischen Elements hinaus und überdeckt vorzugsweise ein Teil der an die Unterseite des sekundären optischen Elements anschließenden seitlichen Oberfläche des sekundären optischen Elements.

Gemäß einer bevorzugten Ausführungsform ist auf der Oberseite des Trägers eine Schutzdiode, vorzugsweise ausgebildet als Bypassdiode, angeordnet und weist eine elektrische Verbindung mit dem ersten Leiterbahnbereich und dem zweiten Leiterbahnbereich auf, d. h. die Schutzdiode Ist mit dem ersten Leiterbahnbereich und dem zweiten Leiterbahnbereich verschaltet. Es sei angemerkt, dass die Solarzelle auch eine Diodencharakteristik aufweist und die Schutzdiode antiparallel zu der Solarzelle geschaltet ist. Die aus der Oberseite des Trägers hervorstehenden Flächen der Schutzdiode sind vorzugsweise von der Polymerkleberschicht bedeckt.

In einer anderen Weiterbildung weist der Träger wenigstens in einer Richtung vorzugsweise in beiden innerhalb der Oberseitenebene des Trägers ausgebildeten Richtungen eine größere laterale Ausdehnung als das sekundäre optische Element auf. Untersuchungen haben gezeigt, dass hierdurch gemäß einer Weiterbildung die Polymerkleberschicht seitlich über die Fläche an der Unterseite des sekundären optischen Elements übersteht und eine besonders starke kraftschlüssige Verbindung des sekundären optischen Elements mit dem Träger erzielen lässt.

In einer Ausführungsform ist das sekundäre optische Element in Form eines halben Ellipsoids ausgebildet und weist vorzugsweise einen umlaufenden absatzförmigen Kragen auf.

Des Weiteren ist es bevorzugt, das sekundäre optische Element einstückig aus einem anorganischen Material, vorzugsweise aus einer Quarzglasverbindung, auszubilden. Ein Vorteil des anorganischen Material bzw. der Quarzglasverbindung ist die sehr gute UV-Transparenz und die außerordentliche hohe Temperaturstabilität sowie eine große mechanische und chemische Widerstandsfähigkeit im Vergleich zu einer organischen bzw. Kunststoff-Verbindung. Bei einer anderen Weiterbildung ist an der Unterseite des Trägers eine Metallschicht als Teil des Trägers ausgebildet, wobei die Metallschicht vorzugsweise in einem umlaufenden Randbereich unmittelbar am Rand des Trägers nicht ausgebildet ist. Ein Vorteil der Metallschicht ist, dass gegenüber einem Träger ohne rückseitige Metallschicht, die Wärme von der Oberseite des Trägers gleichmäßiger auf den gesamten Träger übertragen wird. Untersuchungen haben gezeigt, dass durch die gleichmäßigere Verteilung der Wärme auch eine höhere Abstrahlung von der Unterseite erfolgt. Ferner lässt sich bei einer Montage des Trägers auf einer Unterlage mittels der rückseitigen Metallschicht der Wärmeübergangswiderstand zwischen der Unterlage und dem Träger reduzieren.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnitt auf eine erfindungsgemäße Ausführungsform einer Solarzelleneinheit,
- Figur 2: eine Draufsicht auf die Ausführungsform der Figur 1 mit einer Schutzdiode,
- Figur 3: eine Querschnittsansicht entlang der Linie I-I auf die Ausführungsform der Figur 2,
- Figur 4a: eine Draufsicht von Oben auf ein sekundäres optisches Element mit einer ellipsodalen Form und einen absatzförmigen Kragen,
- Figur 4b: einen Querschnitt des sekundären optischen Elements der Fig. 4a,
- Figur 4c: eine Draufsicht von unten auf das sekundäre optische Element der Fig. 4a,
- Figur 5a: eine Draufsicht von Oben auf ein sekundäres optisches Element einer ellipsodalen Form ohne einen absatzförmigen Kragen,
- Figur 5b: einen Querschnitt auf das sekundäre optische Element der Fig. 5a,
- Figur 5c: eine Draufsicht von unten auf das sekundäre optische Element der Fig. 5a.

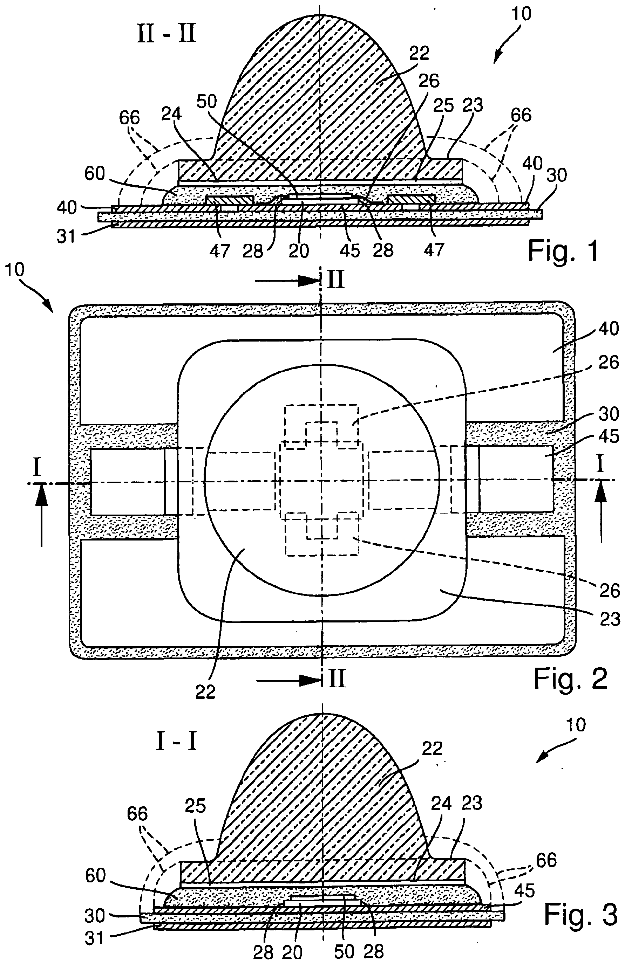

Die Abbildung der Figur 1 zeigt eine Solarzelleneinheit 10 mit einem als Solarzelle ausgebildeten Halbleiterkörper 20, einem sekundären optischen Element 22 in Form eines halben Ellipsoids mit einem umlaufenden kragenförmigen Wulst 23. Das sekundäre optische Element 22 weist eine Unterseite 24 auf und führt das In das sekundäre optische Element 22 einfallende Licht auf die Vorderseite des Halbleiterkörpers 20. Das optische Element 22 weist an der gesamten Unterseite 24 eine plane Oberfläche auf, wobei ein Teil der planen Oberfläche oberhalb einer Vorderseite des Halbleiterkörpers 20 angeordnet ist. An der gesamten Unterseite 24 ist eine stoffschlüssig mit der Unterseite 24 verbundene erste Haftvermittlerschicht 25 ausgebildet. Der Träger 30 weist an der Unterseite eine bis auf einen schmalen Randbereich ganzflächige Metallschicht 31 auf. Der Träger 30 weist außerdem eine größere laterale Ausdehnung als das sekundäre optische Element 22 auf.

Ferner weist der Halbleiterkörper 20 eine Vorderseite mit einem ersten elektrischen Anschluss und eine Rückseite mit einem zweiten elektrischen Anschluss und eine zwischen der Vorderseite und der Rückseite ausgebildete Seitenfläche 28 auf. Der erste elektrische Anschluss ist mittels mehreren geschweißten Verbindern 26 mit dem ersten Leiterbahnbereich 40 elektrisch verschaltet. Der Halbleiterkörper 20 Ist mit der Rückseite auf einer Oberseite eines Trägers 30 angeordnet. An der Oberseite des Trägers 30 ist ein erster als Teil des Trägers ausgebildeter Leiterbahnbereich 40 ausgebildet. Der erste Leiterbahnbereich 40 Ist mit dem ersten elektrischen Anschluss verschaltet. Des Weiteren weist der Träger 30 auf der Oberseite einen zweiten als Teil des Trägers 30 ausgebildeten Leiterbahnbereich 45 auf. Der zweite Leiterbahnbereich 45 und der zweite elektrische Anschluss sind miteinander elektrisch verschaltet, indem die Rückseite des Halbleiterkörpers 20 auf dem zweiten Leiterbahnbereich 45 aufgelötet ist. Ferner sind auf der Oberseite des Trägers 30 zwei Schutzdioden angeordnet. Die Schutzdioden sind als Bypass-Dioden 47 ausgebildet. Es versteht sich, dass mit einer anderen Dimensionierung der Schutzdioden auch eine einzelne Schutzdiode hinreichend ist.

Auf der Vorderseite des Halbleiterkörpers 20 ist eine zweite Haftvermittlerschicht 50 ausgebildet und die zweite Haftvermittlerschicht 50 ist mit der Vorderseite des Halbleiterkörpers stoffschlüssig verbunden. In einer nicht darstellten Ausführungsform überdeckt die zweite Haftvermittlerschicht 50 wenigstens einen Teil der Oberseite des Trägers 30. Zwischen der ersten Haftvermittlerschicht 25 und der zweiten Haftvermittlerschicht 50 bzw. Oberseite des Trägers 30 ist als eine Polymerkleberschicht eine Silikonschicht 60 ausgebildet. Die Silikonschicht 60 füllt in Form einer Vergussmasse den Raum zwischen der Unterseite 24 des sekundären optischen Elements 22 und dem Träger 30 formschlüssig vollständig aus und stellt eine kraftschlüssige Verbindung zwischen dem sekundären optischen Element 22 und dem Träger 30 her. Die Silikonschicht 60 überdeckt sowohl die Seitenflächen des Halbleiterkörpers 20 als auch die aus der Oberseite des Trägers 30 herausstehenden Flächen der beiden Schutzdioden. Es versteht sich, dass die erste Haftvermittlerschicht 25 und / oder die zweite Haftvermittlerschicht 50 eine im Vergleich zu der Polymerkleberschicht bzw. der Silikonschicht 60 unterschiedliche chemische Zusammensetzung aufweisen. In einer alternativen Ausführungsform, dargestellt durch gestrichelte Linien 66 ragt die Silikonschicht 60 seitlich an der Unterseite 24 des sekundären optischen Elements 22 unterschiedlich weit hinaus.

Die Abbildung der Figur 2 zeigt eine Draufsicht auf die Ausführungsform der Figur 1. Nachfolgend werden nur die Unterschiede zu der Darstellung in der Figur 1 erläutert. Es zeigt sich, dass die laterale Ausdehnung des sekundären optischen Elements 22 inklusive des umlaufenden Kragens 23 kleiner als die Ausdehnung des Trägers 30 Ist. Zur Veranschaulichung sind die beiden Schweißverbinder 26 mit denen die Vorderseite des Halbleiterkörpers 20 elektrisch angeschlossen sind, als gestrichelte Linien gezeichnet.

Die Abbildung der Figur 3 zeigt einen weiteren Querschnitt entlang der Linie I-I auf die Ausführungsform der Figur 1. Nachfolgend werden nur die Unterschiede zu der Darstellung In der Figur 1 erläutert. Es zeigt sich, dass die Polymerkleberschicht je nach laterale Ausdehnung, dargestellt durch die gestrichelten Linien 66 bis an den Rand des Trägers 20 ausgebildet ist.

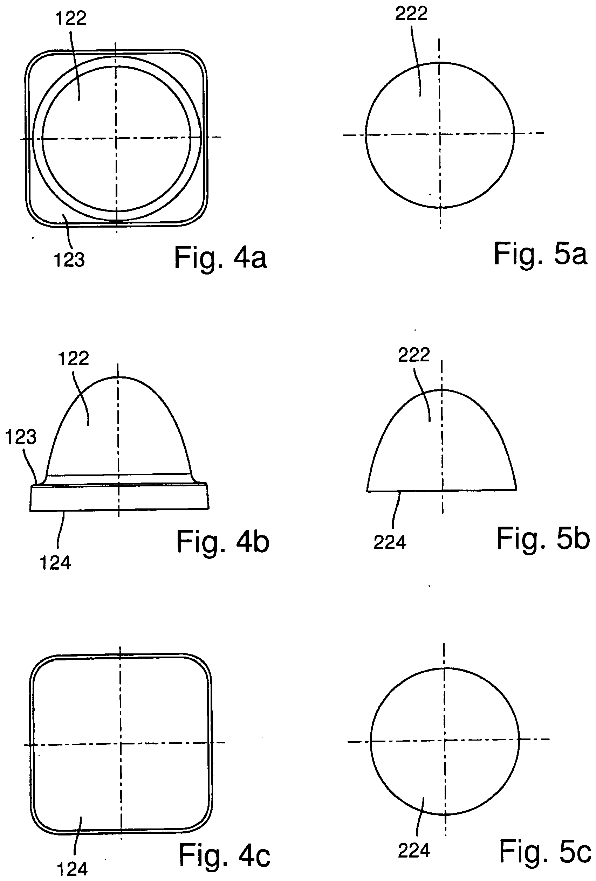

Die Abbildung der Figur 4a zeigt eine Draufsicht von Oben auf eine weitere Ausführungsform eines sekundären optischen Elements mit einer ellipsodalen Form und einen im Vergleich zu dem sekundären optischen Element der Figur 1 kleineren absatzförmigen Kragen 124. Die Abbildung der Figur 4b zeigt eine Querschnittsansicht der Ausführungsform der Figur 4a und die Figur 4c eine Draufsicht von unten auf das sekundäre optische Element der Flg. 4a. Es zeigt sich bei der Draufsicht von unten, dass die Unterseite 124 plan ausgebildet ist.

Die Abbildung der Figur 5a zeigt eine Draufsicht von Oben auf eine weitere Ausführungsform eines sekundären optischen Elements 222 mit einer ellipsodalen Form, jedoch ohne absatzförmigen Kragen. Die Abbildung der Figur 5b zeigt eine Querschnittsansicht der Ausführungsform der Figur 5a und die Figur 5c eine Draufsicht von unten auf das sekundäre optische Element 222 der Fig. 5a. Es zeigt sich bei der Draufsicht von unten, dass die Unterseite 224 wiederum plan ausgebildet ist.

## Patentansprüche

1. Solarzelleneinheit (10) mit,
- einem als Solarzelle ausgebildeten Halbleiterkörper (20), aufweisend eine Vorderseite mit einem ersten elektrischen Anschluss und eine Rückseite mit einem zweiten elektrischen Anschluss und eine zwischen der Vorderseite und der Rückseite ausgebildete Seitenfläche (28), und
- einem Träger (30) mit einer Oberseite und einer Unterseite, wobei der Träger (30) auf der Oberseite einen ersten als Teil des Trägers (30) ausgebildeten Leiterbahnbereich (40) aufweist und der erste elektrische Anschluss mit dem ersten Leiterbahnbereich (40) elektrisch verschaltet ist, und der Träger (30) auf der Oberseite einen zweiten als Teil des Trägers (30) ausgebildeten Leiterbahnbereich (45) aufweist und der zweite elektrische Anschluss mit dem zweiten Leiterbahnbereich (45) elektrisch verschaltet ist,
- einem sekundären optischen Element (22), das eine Unterseite (24) aufweist, wobei das sekundäre optische Element (22) Licht auf die Vorderseite des Halbleiterkörpers (20) führt,
- das sekundäre optische Element (22) an der gesamten Unterseite (24) eine plane Oberfläche aufweist, und
- ein Teil der planen Oberfläche oberhalb der Vorderseite des Halbleiterkörpers (20) angeordnet ist,
**dadurch gekennzeichnet, dass**
- ein Teil der Unterseite (24) eine stoffschlüssig mit der Unterseite (24) verbundene erste Haftvermittlerschicht (25) aufweist und eine Polymerkleberschicht (60) wenigstens zwischen der ersten Haftvermittlerschicht (25) und der Vorderseite des Halbleiterkörpers (20) und ohne Begrenzung für eine laterale Ausdehnung ausgebildet ist,
- die Polymerkleberschicht (60) als Vergussmasse an der gesamte Unterseite (24) des sekundären optischen Elementes ausgebildet ist und die Vorderseite des Halbleiterkörpers (20) und die Seitenflächen (28) des Halbleiterkörpers (20) formschlüssig überdeckt,
- die Polymerkleberschicht (60) kissenförmig ausgebildet ist,
- das sekundäre optische Element (22) eine ellipsoidale Form aufweist oder in Form eines halben Ellipsoids ausgebildet ist, und
- das sekundäre optische Element (22) einstückig aus einem anorganischen Material ausgebildet ist.

2. Solarzelleneinheit (10) nach Anspruch 1, **dadurch gekennzeichnet, dass** zwischen der Polymerkleberschicht (60) und der Vorderseite des Halbleiterkörpers (20) eine zweite Haftvermittlerschicht (50) ausgebildet ist und die zweite Haftvermittlerschicht (50) mit der Vorderseite des Halbleiterkörpers (20) stoffschlüssig verbunden ist.

3. Solarzelleneinheit (10) nach einem der vorstehenden Ansprüche, **dadurch gekennzeichnet, dass** die erste Haftvermittlerschicht (25) mit der Oberfläche an der gesamten Unterseite (24) des sekundären optischen Elements (22) stoffschlüssig verbunden ist.

4. Solarzelleneinheit (10) nach einem der vorstehenden Ansprüche, **dadurch gekennzeichnet, dass** die Polymerkleberschicht (60) seitlich an der Unterseite des sekundären optischen Elements (22) hinausragt.

5. Solarzelleneinheit (10) nach einem der vorstehenden Ansprüche, **dadurch gekennzeichnet, dass** die Polymerkleberschicht (60) einen Teil der an die Unterseite (24) des sekundären optischen Elements (22) anschließenden seitlichen Oberfläche überdeckt.

6. Solarzelleneinheit (10) nach einem der vorstehenden Ansprüche, **dadurch gekennzeichnet, dass** die Polymerkleberschicht (60) eine Silikonverbindung umfasst.

7. Solarzelleneinheit (10) nach einem der vorstehenden Ansprüche, **dadurch gekennzeichnet, dass** die erste Haftvermittlerschicht (25) und / oder die zweite Haftvermittlerschicht (50) eine im Vergleich zu der Polymerkleberschicht (60) unterschiedliche chemische Zusammensetzung aufweisen.

8. Solarzelleneinheit (10) nach einem der vorstehenden Ansprüche, **dadurch gekennzeichnet, dass** auf der Oberseite des Trägers (30) eine Bypassdiode (47) angeordnet ist und die Bypassdiode (47) zwischen der Unterseite des sekundären optischen Elements (22) und dem Träger (30) angeordnet ist und von der Polymerkleberschicht (60) vollständig überdeckt ist.

9. Solarzelleneinheit (10) nach einem der vorstehenden Ansprüche, **dadurch gekennzeichnet, dass** der Träger (30) eine größere laterale Ausdehnung als das sekundäre optische Element (22) aufweist.

10. Solarzelleneinheit (10) nach einem der vorstehenden Ansprüche, **dadurch gekennzeichnet**, die Polymerkleberschicht (60) eine Dicke unterhalb von 2mm oder eine Dicke unterhalb von 0,5 mm aufweist.

11. Solarzelleneinheit (10) nach einem der Ansprüche 1 bis 10, **dadurch gekennzeichnet, dass** das sekundäre optische Element (22) einen umlaufenden absatzförmigen Kragen (23) aufweist.

12. Solarzelleneinheit (10) nach einem der Ansprüche 1 bis 10, **dadurch gekennzeichnet, dass** die erste und/oder die zweite Haftvermittlerschicht (25, 50) eine Dicke von weniger als 0,5 mm oder eine Dicke von weniger als 0,05 mm aufweist.

13. Solarzelleneinheit (10) nach einem der vorstehenden Ansprüche, **dadurch gekennzeichnet, dass** das anorganische Material des einstückigen sekundären optischen Elements (22) eine Quarzglasverbindung ist.

14. Solarzelleneinheit (10) nach einem der vorstehenden Ansprüche, **dadurch gekennzeichnet, dass** es zusätzlich ein primäres optisches Element aufweist und das sekundäre optische Element (22) das durch das oberhalb des sekundären optischen Elements (22) ausgebildete primäre optische Element gebündelte Licht auf die Vorderseite des Halbleiterbauelements (20) führt.

## Claims

1. Solar cell unit constructed with
- a semiconductor body (20), which is constructed as a solar cell and which has a front side with a first electrical connection and a rear side with a second electrical connection and a side surface (28) formed between the front side and the rear side, and
- a support (30) with an upper side and a lower side,
wherein the support (30) has on the upper side a first conductor track region (40), which is formed as part of the support (30), the first electrical connection being electrically connected with the first conductor track region (40), and the support (30) has on the upper side a second conductor track region (45), which is formed as part of the support (30), the second electrical connection being electrically connected with the second conductor track region (45),
- a secondary optical element (22) which has a lower side (24), wherein the secondary optical element (22) conducts light to the front side of the semiconductor body (20),
- the secondary optical element (22) has a planar surface at the entire lower side (24) and
- a part of the planar surface is arranged above the front side of the semiconductor body (20),
**characterised in that**
- a part of the lower side (24) comprises an adhesion-promoting layer (25), which is connected by material couple with the lower side (24), and a polymer adhesive layer (60) is formed at least between the first adhesion-promoting layer (25) and the front side of the semiconductor body (20) and without limitation or lateral expansion,
- the polymer adhesive layer (60) is formed as a cast mass at the entire lower side (24) of the secondary optical element and covers in shape-locking manner the front side of the semiconductor body (20) and the side surfaces (28) of the semiconductor body (20),
- the polymer adhesive layer (60) is formed to be pillow shaped,
- the secondary optical element (22) has an ellipsoidal form or is constructed in the form of a half ellipsoid, and
- the secondary optical element (22) is formed integrally from an inorganic material.

2. Solar cell unit (10) according to claim 1, **characterised in that** a second adhesion-promoting layer (50) is formed between the polymer adhesive layer (60) and the front side of the semiconductor body (20) and the second adhesion-promoting layer (50) is connected with the front side of the semiconductor body (20) by material couple.

3. Solar cell unit (10) according to one of the preceding claims, **characterised in that** the first adhesion-promoting layer (25) is connected with the surface at the entire lower side (24) of the secondary optical element (22) by material couple.

4. Solar cell unit (10) according to any one of the preceding claims, **characterised in that** the polymer adhesive layer (60) projects laterally of the lower side of the secondary optical element (22).

5. Solar cell unit (10) according to any one of the preceding claims, **characterised in that** the polymer adhesive layer (60) covers a part of the lateral surface connected with the lower side (24) of the secondary optical element (22).

6. Solar cell unit (10) according to any one of the preceding claims, **characterised in that** the polymer adhesive layer (60) comprises a silicon compound.

7. Solar cell unit (10) according to any one of the preceding claims, **characterised in that** the first adhesion-promoting layer (25) and/or the second adhesion-promoting layer (50) has or have a different chemical composition by comparison with the polymer adhesive layer (60).

8. Solar cell unit (10) according to any one of the preceding claims, **characterised in that** a bypass diode (47) is arranged on the upper side of the support (30) and the bypass diode (47) is arranged between the lower side of the secondary optical element (22) and the support (30) and completely covered by the polymer adhesive layer (60).

9. Solar cell unit (10) according to any one of the preceding claims, **characterised in that** the support (30) has a greater lateral extent than the secondary optical element (22).

10. Solar cell unit (10) according to any one of the preceding claims, **characterised in that** the polymer adhesive layer (60) has a thickness below 2 millimetres or a thickness below 0.5 millimetres.

11. Solar cell unit (10) according to any one of claims 1 to 10, **characterised in that** the secondary optical element (22) has an encircling shoulder-shaped collar (23).

12. Solar cell unit (10) according to any one of claims 1 to 10, **characterised in that** the first and/or the second adhesion-promoting layer (25, 50) has a thickness less than 0.5 millimetres or a thickness of less than 0.05 millimetres.

13. Solar cell unit (10) according to any one of the preceding claims, **characterised in that** the inorganic material of the integral secondary optical element (22) is a quartz glass composite.

14. Solar cell unit (10) according to any one of the preceding claims, **characterised in that** it additionally comprises a primary optical element and the secondary optical element (22) conducts, to the front side of the semiconductor component (20), light focused by the primary optical element which is formed above the second optical element (22).

## Revendications

1. Unité de cellules solaires (10), comprenant :
- un corps à semi-conducteur (20) réalisé sous la forme d'une cellule solaire et présentant un côté avant pourvu d'un premier raccord électrique et un côté arrière pourvu d'un second raccord électrique et une face latérale (28) qui est formée entre le côté avant et le côté arrière, et
- un support (30) qui présente un côté supérieur et un côté inférieur,
dans laquelle le support (30) comporte sur le côté supérieur une première zone de pistes conductrices (40) qui est réalisée sous la forme d'une partie du support (30), et le premier raccord électrique est électriquement connecté à la première zone de pistes conductrices (40), et le support (30) comporte sur le côté supérieur une seconde zone de pistes conductrices (45) qui est réalisée sous la forme d'une partie du support (30), et le second raccord électrique est électriquement connecté à la seconde zone de pistes conductrices (45),
- un élément optique secondaire (22) qui présente un côté inférieur (24), dans laquelle l'élément optique secondaire (22) guide de la lumière sur le côté avant du corps à semi-conducteur (20),
- l'élément optique secondaire (22) présente une surface plane sur la totalité du côté inférieur (24), et
- une partie de la surface plane est disposée au-dessus du côté avant du corps à semi-conducteur (20),
**caractérisée en ce que** :
- une partie du côté inférieur (24) comporte une première couche d'agent adhésif (25) qui est matériellement assemblée au côté inférieur (24) et une couche de colle polymère (60) qui est formée au moins entre la première couche d'agent adhésif (25) et le côté avant du corps à semi-conducteur (20) et sans limitation pour une extension latérale,
- la couche de colle polymère (60) est réalisée sous la forme d'une masse de moulage sur la totalité du côté inférieur (24) de l'élément optique secondaire et recouvre en complémentarité de forme le côté avant du corps à semi-conducteur (20) ainsi que les faces latérales (28) du corps à semi-conducteur (20)
- la couche de colle polymère (60) est réalisée en forme de coussin,
- l'élément optique secondaire (22) présente une forme ellipsoïdale ou est configuré en forme de demi-ellipsoïde, et
- l'élément optique secondaire (22) est réalisé d'une seule pièce en un matériau inorganique.

2. Unité de cellules solaires (10) selon la revendication 1, **caractérisée en ce qu'**une seconde couche d'agent adhésif (50) est formée entre la couche de colle polymère (60) et le côté avant du corps à semi-conducteur (20) et la seconde couche d'agent adhésif (50) est matériellement assemblée au côté avant du corps à semi-conducteur (20).

3. Unité de cellules solaires (10) selon l'une quelconque des revendications précédentes, **caractérisée en ce que** la première couche d'agent adhésif (25) est matériellement assemblée à la surface de la totalité du côté inférieur (24) de l'élément optique secondaire (22).

4. Unité de cellules solaires (10) selon l'une quelconque des revendications précédentes, **caractérisée en ce que** la couche de colle polymère (60) déborde latéralement sur le côté inférieur de l'élément optique secondaire (22).

5. Unité de cellules solaires (10) selon l'une quelconque des revendications précédentes, **caractérisée en ce que** la couche de colle polymère (60) recouvre une partie de la surface latérale qui se raccorde au côté inférieur (24) de l'élément optique secondaire (22).

6. Unité de cellules solaires (10) selon l'une quelconque des revendications précédentes, **caractérisée en ce que** la couche de colle polymère (60) comprend un composé de silicium.

7. Unité de cellules solaires (10) selon l'une quelconque des revendications précédentes, **caractérisée en ce que** la première couche d'agent adhésif (25) et/ou la seconde couche d'agent adhésif (50) présente(nt) une composition chimique différente de celle de la couche de colle polymère (60).

8. Unité de cellules solaires (10) selon l'une quelconque des revendications précédentes, **caractérisée en ce qu'**une diode de dérivation (47) est disposée sur le côté supérieur du support (30), et la diode de dérivation (47) est disposée entre le côté inférieur de l'élément optique secondaire (22) et le support (30) et est entièrement recouverte par la couche de colle polymère (60).

9. Unité de cellules solaires (10) selon l'une quelconque des revendications précédentes, **caractérisée en ce que** le support (30) présente une plus grande extension latérale que l'élément optique secondaire (22).

10. Unité de cellules solaires (10) selon l'une quelconque des revendications précédentes, **caractérisée en ce que** la couche de colle polymère (60) présente une épaisseur inférieure à 2 mm ou une épaisseur inférieure à 0,5 mm.

11. Unité de cellules solaires (10) selon l'une quelconque des revendications 1 à 10, **caractérisée en ce que** l'élément optique secondaire (22) présente un collet périphérique en forme d'épaulement (23).

12. Unité de cellules solaires (10) selon l'une quelconque des revendications 1 à 10, **caractérisée en ce que** la première couche et/ou la seconde couche d'agent adhésif (25, 50) présente(nt) une épaisseur inférieure à 0,5 mm ou une épaisseur inférieure à 0,05 mm.

13. Unité de cellules solaires (10) selon l'une quelconque des revendications précédentes, **caractérisée en ce que** le matériau inorganique de l'élément optique secondaire d'une seule pièce (22) est un composé de verre de quartz

14. Unité de cellules solaires (10) selon l'une quelconque des revendications précédentes, **caractérisée en ce qu'**elle comprend en outre un élément optique primaire, et l'élément optique secondaire (22) guide la lumière focalisée par l'élément optique primaire qui est formé au-dessus de l'élément optique secondaire (22) vers le côté avant de l'élément à semi-conducteur (20).
